Europäisches Patentamt

European Patent Office

Office européen des brevets

(11) Publication number: 0 244 171
A1

## (12) EUROPEAN PATENT APPLICATION

(21) Application number: 87303660.2

(22) Date of filing: 24.04.87

(51) Int. Cl.⁴: H 01 L 29/72
H 01 L 29/10, H 01 L 21/265

(30) Priority: 28.04.86 GB 8610314

(43) Date of publication of application:
04.11.87 Bulletin 87/45

(84) Designated Contracting States:
AT BE CH DE ES FR GB GR IT LI LU NL SE

(71) Applicant: BRITISH TELECOMMUNICATIONS PUBLIC
LIMITED COMPANY
81 Newgate Street
London EC1A 7AJ (GB)

(72) Inventor: Welbourn, Anthony David
7, Fishbane Close
Ipswich Suffolk IP3 0SE (GB)

Chandler, Timothy John
8, Longcroft Road
Colchester Essex CO4 3AR (GB)

(74) Representative: Purell, Kevin John et al
British Telecom Intellectual Property Unit 13th Floor 151
Gower Street
London WC1E 6BA (GB)

The title of the invention has been amended (Guidelines for Examination in the EPO, A-III, 7.3).

(54) Bipolar transistor having an implanted extrinsic base region.

(57) A bipolar fabrication process uses the emitter contact resist mask, used when cutting the emitter contact (13), as an implantation mask during implantation of the extrinsic base region (14). The resist prevents unwanted doping of the emitter contact (13).

Fig. 5.

## Description

### BIPOLAR TRANSISTOR

This invention relates to a method of making a bipolar transistor having an implanted extrinsic base region.

Currently integrated bipolar transistors are mainly used for high speed memory and logic circuits. In order to increase the speed of operation of such memory and logic circuits it is desirable to increase the operating speed of bipolar transistors. The fastest (silicon) bipolar devices currently available are produced using "self-aligned" processes. These processes eliminate the alignment tolerances necessary from one mask to another which in advanced bipolar transistors give rise to most of the important parasitic elements (such as base resistance and collector-base capacitance) of the transistor. However, self-aligned processes tend to be considerably more complex than are conventional processes. Specifically, self aligned processes generally involve many more processing steps and may require the use of new or unusual processing steps with the consequent expectation of lower process yields.

An example of a complex self-aligned process, for making walled-emitter devices, can be found in the paper by Takemoto et al in IEEE Transactions on electron devices, Vol. ED29, No.11, November 1982, pp 1761-1765. The extrinsic base is aligned to the emitter by implanting the extrinsic base dopant using the polysilicon emitter contact as a mask. The necessary separation between the n+ emitter region and the p+ extrinsic base is provided by oxide-filled slots etched in the silicon surface.

Unfortunately not only does the use of oxide-filled slots result in the process being very complex, but the polysilicon emitter contact is doped with both arsenic, the emitter dopant, and boron, the extrinsic base dopant. The problems of dopant segregation, which are likely to be quite severe in the polysilicon, become worse as the proportion of boron rises, and this limits the level of doping which can reasonably be used in the extrinsic base.

Consequently there exists a need for a method of making bipolar transistors which does not suffer from the complexities of the self-aligned processes, but which still enables the production of transistors which are capable of working at clock rates greater than those achievable by transistors produced conventionally, ie transistors capable of operating at clock rates in excess of 2 GHz.

According to the present invention there is provided a method of making a bipolar transistor having an implanted extrinsic base region, wherein the method includes the steps of:

    a) forming an active base region in a body of semiconductor material;

    b) depositing over the base region a layer of material which is to form the emitter control;

    c) depositing a layer of resist material over a layer which is to form the emitter contact;

    d) defining a pattern in said resist layer;

    e) etching the emitter contact layer using the patterned resist layer as a mask, to define an emitter contact; and

    f) implanting the extrinsic base region using the emitter contact and the resist remaining after step (e) as a mask.

By using the emitter contact as a mask during the implantation of the extrinsic base region it is possible to pseudo self-align the extrinsic base to the emitter with a spacing of about 0.5um. Device performance is improved by reducing both collector-base capacitance and base resistance. Furthermore, even using a 2um minimum lithography and a 6um metal pitch it has been possible to produce devices having an $f_T$ (the frequency at unity common emitter current gain) of 6 to 7 GHz coupled with an f max (the frequency at unity power gain) of 5 to 7 GHz and a nominal current gain of 100.

A further advantage of this method is that the resist used in defining the emitter contact can largely prevent extrinsic base dopant penetrating the emitter contact. Consequently the amount of base dopant which penetrates the emitter contact and the amount which reaches the emitter region are kept very low even when very high levels of doping are required in the extrinsic base.

Hence this method overcomes the problem of emitter compensation by the extrinsic base dopant which is found in other methods, such as that of Takemoto, Fujita, Kawakita and Sakai, and which limits the level of extrinsic base doping which is obtainable. The amount of dopant which is implanted in the extrinsic base region is thus not limited by other processing requirements.

An additional benefit, which results from the resist limiting penetration of the emitter contact material, is that the emitter contact does not become so doped with base dopant that it acts as a dopant source for the 'wrong' species during subsequent processing.

Preferably the emitter contact layer comprises polysilicon, which enables a very shallow emitter, with a base-emitter junction depth of about 0.1μm, to be formed.

Preferably the base region will also be contacted by a polysilicon layer. If this polysilicon layer is in turn contacted by metal away from the active regions of the device the base junction area can be reduced with a consequent reduction in the collector-base capacitance, without having to correspondingly reduce the metal line pitch.

Preferred embodiments of the present invention will now be described by way of example with reference to the accompanying figures, in which:

    Figs 1 to 11 are diagrammatic representations of the various stages in the process according to the present invention;

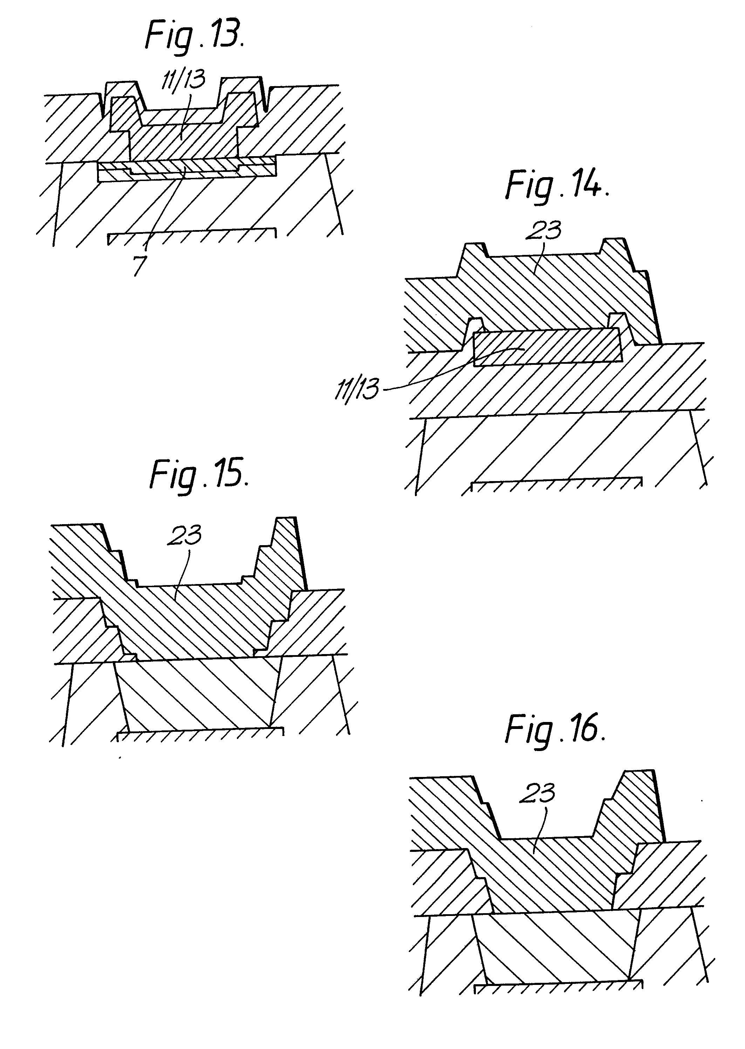

    Figs 12 to 16 are diagrammatic representations of cross sections through various significant regions of a transistor obtained by means of the process.

In the figures and in the following description, production of an npn transistor is described, but as those skilled in the art will be aware pnp transistors may also be produced by essentially the same process by substituting p-type for n-type and n-type for p-type and changing the dopant species as appropriate. However, as those skilled in the art will also be aware, pnp transistors are inherently slower in operation than are npn transistor and the performance figures given in this specification should be taken as applying to npn transistors and not to pnp transistors.

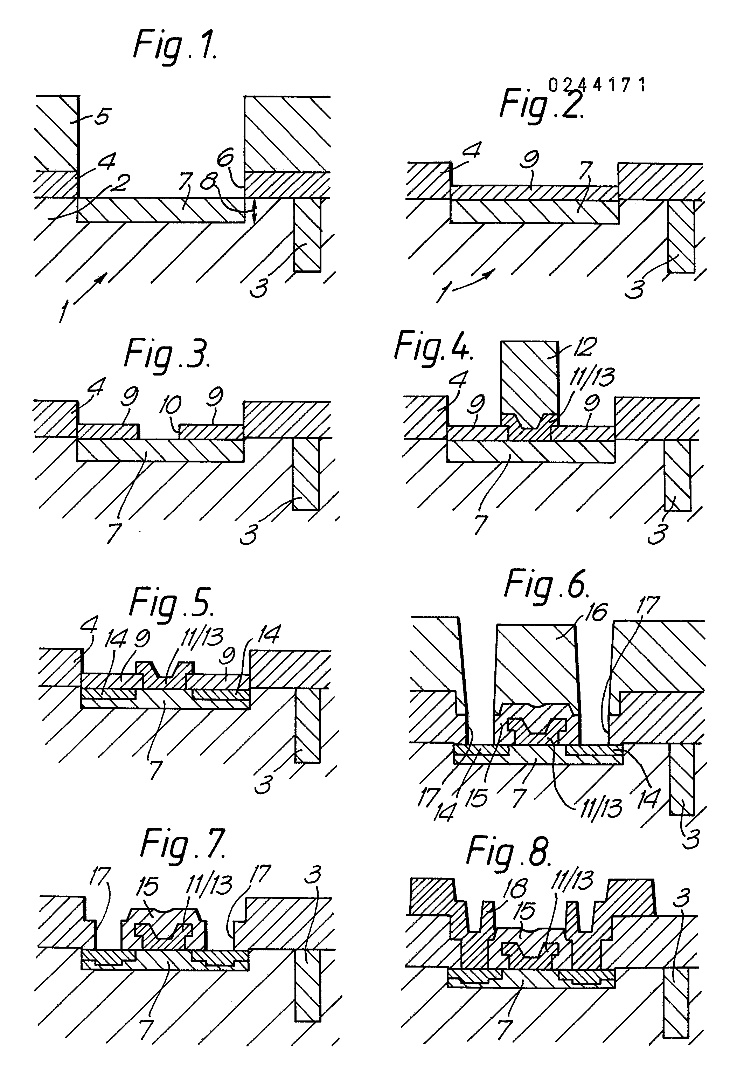

In figure 1 an n-type epitaxial layer 2 of silicon, with a resistivity of about 2 ohm cm, is grown to a thickness of 2 to 3um on a p-type silicon substrate 1. The transistor's collector contact is to be effected through the top surface of the slice and a deep high concentration diffusion 3 is provided to help reduce collector series resistance. A field oxide layer 4 is formed to a depth of about 0.35$\mu$m. This pre-base (field) oxide provides the differential oxide thickness for the extrinsic base implant masking and hence its thickness should not be reduced too far. A resist layer 5 is then deposited over the oxide layer 4 and a window 6 etched for the intrinsic base implant. The intrinsic base 7 is implanted using the resist to mask the field oxide 4. The intrinsic base may be implanted using two implants such as boron difluoride ($BF_2$) and boron (B). The base collector junction depth 8 may be between 0.25 and 0.30 $\mu$m. By using the resist 5 to mask the oxide 4 problems of having to etch boron implanted oxide are avoided and the oxide's dopant concentration is kept low.

In Figure 2, a base oxide layer 9 is formed to a thickness of about 0.2$\mu$m and the implants annealed. The base oxide can be the combination of a thin grown oxide ( $\simeq$ 500A) and a deposited oxide ( $\simeq$ 1.5 $\mu$m), or can be completely deposited ( $\simeq$ 2 $\mu$m). To avoid excessive diffusion of the dopants a rapid transient (RT) anneal, such as a Heatpulse anneal, is recommended.

In Figure 3 the emitter window 10 is produced by etching. Although wet etching can be used, plasma etching allows better linewidth control which is beneficial here as the size of the emitter window is a critical feature.

In Figure 4 the emitter contact layer 11 is deposited, covered with a resist layer 12 (typically a photoresist) and a pattern defined and etched to leave an emitter contact 13 under a layer of resist (typically about 1 um thick). Preferably the emitter contact layer 11 comprises polysilicon, although polycide (silicided polysilicon) could be used. A metal emitter contact is not recommended as it would require the use of an unsatisfactory deep emitter. If polysilicon is used for the emitter contact layer, a thickness of between 0.15 and 0.2 $\mu$m is appropriate. With thicknesses above about 0.2 $\mu$m gain improves only marginally, whereas the emitter resistance and transit time degrade markedly. With a thickness of less than about 0.15 $\mu$m, surface recombination affects the current gain and there are problems with implant penetration through the polysilicon. A polysilicon emitter contact layer may be implanted using arsenic at an energy at which the arsenic is entirely stopped in the polysilicon. The emitter region is then formed by carrying out a dopant drive step to a point where the dopant has penetrated about 0.1 $\mu$m into the base region under the emitter window 10.

In Figure 5 the extrinsic base 14 has been implanted through the base oxide 9 on either side of the emitter contact 13. As can be seen, the extension of the emitter contact 13 beyond the periphery of the emitter window serves to ensure that the extrinsic base (p+) is not formed too close to the emitter region (n+).

With a boron dopant the implant for the extrinsic base is chosen to place the peak concentration of dopant ions at the oxide/single crystal interface, with an effective extrinsic base depth of about 0.3 $\mu$m, while the doping level at the base-collector junction is increased only marginally by the implant tail. The maximum base oxide thickness that can be used is about 0.25 $\mu$m; above this thickness, the energy of the boron necessary to penetrate the oxide wil also pass through the base and move the base-collector junction. If variations in oxide thickness during processing can be minimised, the implant dose can be increased, which would allow a further reduction in the sheet resistivity of this region. However the effect of the implant on the base and field oxides should be considered. Finally the remaining resist 12 is removed.

In Figure 6 a dielectric layer 15 is deposited. This layer 15 can be a conformal oxide and may be about 0.2 $\mu$m thick. This layer 15 should not be too thin, as the base-emitter capacitance will increase, or too thick, as the final field oxide thickness could present problems when cutting contacts. The extrinsic base anneal and the emitter drive are performed and can be combined; a low temperature furnace step could be used, but a rapid transient anneal is preferred.

A resist layer 16 is deposited over dielectric layer 15, and the base contact windows 17 are printed and etched. This is the first critical alignment step, as the separation between the base-contacts and the emitter defines the width of the extrinsic base region. Again, plasma etching is preferred. The collector contact may also be partially opened at this stage.

In Figure 7 a p+ contact implant is performed using the resist mask 16 from the etching of the base contact windows. There is already a high p+ concentration at the surface, and there will be some outdiffusion from the polysilicon layer 18 next to be deposited. Hence it may not be necessary to perform this step. The remaining resist 16 is stripped.

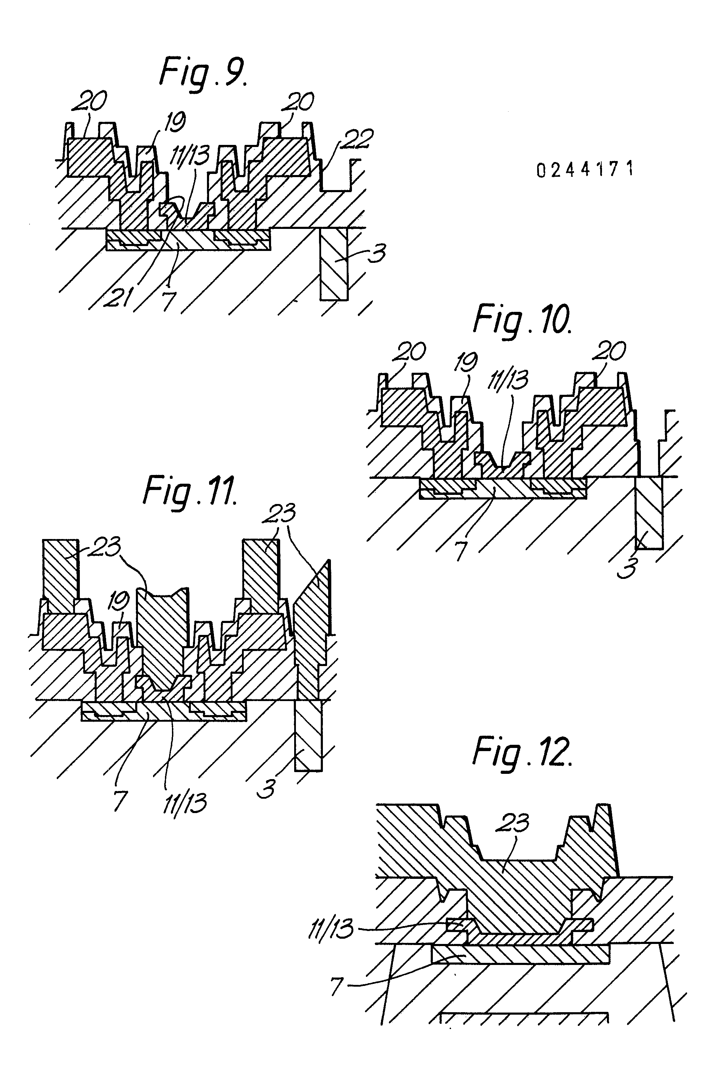

In Figure 8 the base contact layer 18 is deposited, implanted, annealed and etched. Preferably this layer is polysilicon, but polycide could also be used. A polysilicon implant will again be boron, again to be completely stopped in the polysilicon. A short rapid transient anneal is required to redistribute the doping in this polysilicon layer.

In Figure 9 another layer 19 of dielectric, preferably oxide, is deposited to a depth of about 0.2 um. Using a further resist layer (not shown) the base and emitter contact windows 20, 21 are printed and etched and the collector contact window 22 is partly opened. The emitter and base contact windows can be etched in one step; the base contact windows are cut in 0.2 µm of oxide and the emitter contact window in 0.4 µm of oxide. Although this requires over-etching of the base contact windows it is not a problem as their size is no longer (with polysilicon rather than metal base contacts) a critical dimension.

In Figure 10 the collector contact window 22 is opened. The collector may be partially opened at both stages 6 and 9 in the processing, but the combined etch depth at these two stages is insufficient to etch the total thickness of field oxide. In neither of stages 6 or 9 should there be over-etching as that would compromise final device performance. The remaining oxide therefore has to be removed in a separate step. The contact windows may be formed in several ways, using stages 6 + 10, 6 + 9 + 10, or 9 + 10, and the relative size of each etch window can be adjusted to give the best step coverage for the collector metal.

In Figure 11 the metal layer 23 is deposited and subsequently patterned using a conventional lithographic process. As those skilled in the art will be aware, when the transistor is part of a complex integrated circuit further metallisation layers may be provided, insulated by further layers of dielectric.

The thickness of the remaining dielectric/oxide layers is not really critical, and provided that there is sufficient thickness to avoid parasitic device turn on any problems with metal coverage should be eased by reducing the thicknesses of these layers.

In addition to enabling the production of transistors of higher operating speed and lower power dissipation (compared with transistors produced using conventional processes), the invention also enables the production of low value resistors in the polysilicon layers 11 or 18 with reduced parasitic capacitances, as well as the production of low value capacitances.

In conventional processes for the fabrication of bipolar transistors in integrated circuits, resistors are fabricated in the transistor base layer either using the diffused extrinsic base layer directly or by ion implantation as an additional process step. The sheet resistivity of this separately implanted layer is a compromise between that required for the low value (approx. 50-400 ohms) and high value (approx. 1K-10K ohms) resistors. As the low value resistors are the most critical, this compromise is unwelcome. In the present process, low value resistors can be formed in either of the polysilicon layers; the sheet resistivity of 40 to 80 ohm/square being practically ideal. Moreover, because they are isolated by a dielectric, these resistors have a low parasitic capacitance. High value resistors cannot easily be formed in the polysilicon, but can still be defined in the base material. However, these resistors are only normally used for emitter follower loads, where the larger capacitance and less well controlled resistor values can be more easily tolerated.

Using the process according to the invention, low value capacitors (less than about 1pF) can be formed in a number of ways, using either or both of the polysilicon layers and/or the first level of metal as electrodes. With the dielectric thicknesses quoted above, values of about 0.17 and 0.34 fF/$\mu m^2$ can be achieved.

As those skilled in the art will be aware, several variations are possible to the process outlined above while still retaining the benefit of the invention. Among these possible variations the following are perhaps worthy of note.

A conventional emitter could be implanted into the emitter window 10 at step 3, in addition to the polysilicon contact at step 4.

A silicide could be formed in either or both of the polysilicon layers; this would have the advantage of removing the need for metal patterning on some of the contacts.

A refractory metal silicide or equivalent could be formed in the base contact windows 17 of step 7. The second polysilicon layer could then either be omitted completely, patterning metal straight onto this contact, or its proximity to the emitter could be reduced.

## Claims

1. A method of making a bipolar transistor having an implanted extrinsic base region, wherein the method includes the steps of:

(a) forming an active base region in a body of semiconductor material;

(b) depositing over the base region a layer of material which is to form the emitter contact;

(c) depositing a layer of resist material over said layer which is to form the emitter contact;

(d) defining a pattern in said resist layer;

(e) etching the emitter contact layer using the patterned resist layer as a mask, to define an emitter contact; and

(f) implanting the extrinsic base region using the emitter contact and the resist remaining after step (e) as a mask.

2. A method as claimed in claim 1 wherein the extrinsic base region is implanted through a dielectric layer.

3. A method as claimed in claim 1 or claim 2 wherein the emitter contact layer comprises polysilicon.

4. A method as claimed in claim 3 wherein the polysilicon emitter contact layer is implanted with a dopant after it is deposited, the dopant subsequently being driven into an underlying semiconductor region to produce an emitter region less than 0.15µm deep.

5. A bipolar transistor comprising a semiconductor layer within which is implanted an extrinsic base region and an emitter region; electrical connection to said emitter region being provided by an emitter contact on the surface of said semiconductor layer, the emitter contact having been defined using a resist mask on the emitter contact, characterised in that said extrinsic base region is implanted about said emitter region using said emitter contact and said resist as a mask.

6. An integrated circuit comprising a plurality of bipolar transistors made according to the method of any one of claims 1 to 4.

7. An integrated circuit as claimed in claim 6 wherein the base contacts and/or the emitter contacts are polysilicon, polysilicon also being used to provide resistors having resistances in the range 50 to 400 ohms.

Fig.1.

Fig.2.

Fig.3.

Fig.4.

Fig.5.

Fig.6.

Fig.7.

Fig.8.

Fig.9.

Fig.10.

Fig.11.

Fig.12.

0244171

0244171

**Fig.13.**

**Fig.14.**

**Fig.15.**

**Fig.16.**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| D,X | IEEE TRANSACTIONS ON ELECTRON DEVICES, vol. ED-29, no. 11, November 1982, pages 1761-1765, IEEE, New York, US; T. TAKEMOTO et al.: "A vertically isolated self-aligned transistor - VIST" * Abstract; pages 1761-1762, paragraph II; figure 2 * | 5-7 | H 01 L   29/72<br>H 01 L   29/10<br>H 01 L   21/265 |
| D,A | Idem | 1-3 | |
| | --- | | |
| A | IEEE TRANSACTIONS ON ELECTRON DEVICES, vol. ED-32, no. 2, February 1985, pages 242-247, IEEE, New York, US; A. CUTHBERTSON et al.: "Self-aligned transistors with polysilicon emitters for bipolar VLSI" * Page 242-244, paragraph II; figures 1,3 * | 1-7 | |
| | | | TECHNICAL FIELDS SEARCHED (Int. Cl.4) |
| | --- | | H 01 L |
| A | FR-A-2 117 976 (N.V. PHILIPS' GLOEILAMPEFABRIEKEN) * Page 17, line 18 - page 20, line 1; figures 7,8 * | 1,2 | |
| | ----- | | |

The present search report has been drawn up for all claims

| Place of search | Date of completion of the search | Examiner |
|---|---|---|
| THE HAGUE | 24-06-1987 | BAILLET B.J.R. |